# EUROPEAN PATENT APPLICATION

(11) **EP 1 626 448 A2**
(43) Date of publication of application: **15.02.2006**
(21) Application number: 05014658.8
(22) Date of filing: 06.07.2005
(51) Int. Cl.: H01L 51/50, G02F 1/13357

(54) **Lighting apparatus and liquid crystal display apparatus**

(30) Priority: 06.07.2004 JP 2004199742
(71) Applicant: KABUSHIKI KAISHA TOYOTA JIDOSHOKKI, Kariya-shi, Aichi-ken (JP)
(72) Inventor: Ito, Hironori, c/o Kabushiki K. Toyota Jidoshokki, Kariya-shi Aichi-ken (JP); Kato, Yoshifumi c/o Kabushiki K. Toyota Jidoshokki, Kariya-shi Aichi-ken (JP); Noritake, Kazuro, c/o Kabushiki K. Toy. Jodoshokki, Kariya-shi Aichi-ken (JP)
(74) Representative: TBK-Patent

(57) **Abstract**

A liquid crystal display apparatus (11) has a liquid crystal panel (12) and a lighting apparatus (13) arranged at the backside of the liquid crystal panel. The lighting apparatus has an organic electroluminescent device (27) as a light source. The organic electroluminescent device includes a pair of electrodes (24, 25) and an organic layer (26) arranged between the electrodes for emitting light when an electric field is applied to the organic layer. An emission spectrum of the organic electroluminescent device has peak in each of red, green, blue, and cyan wavelength zones. Therefore, the colors of printed objects on the liquid crystal display are accurately reproduced.

## Description

### BACKGROUND OF THE INVENTION

The present invention relates to lighting apparatuses and liquid crystal display apparatuses, and, more particularly, to lighting apparatuses using an electroluminescent devices (EL devices) emitting white light as a light source and liquid crystal display apparatuses including such lighting apparatuses.

Generally, color displays like monitors of television sets or personal computers employ light of three primary colors, red (R), green (G), and blue (B), and form color images by a color mixing method called an additive color mixing method. Currently, each pixel of a typical color display is configured by sub-pixels of red, green, and blue. The light from a white light source is transmitted through color filters of red, green, and blue colors to obtain light of three primary colors.

As the white light source, a fluorescent light or a white light emitting diode (white LED) is often used. Regarding the fluorescent light (the three wavelength tube), a most part of the light emitting intensity is distributed in three wavelength zones corresponding to red, green, and blue. White LEDs include a blue conversion type in which blue light is emitted, passed through a filter and thus converted to orange light, so that the blue light and the orange light are used for forming pseudo white light. White LEDs also include a type in which the light emitting intensity is restricted to the central wavelength zone of each of the colors, red, green, and blue.

It has been proposed that an organic EL device emitting white light may be employed as a backlight of a liquid crystal display (for example, see Japanese Laid-Open Patent Publication No. 2002-229021). More specifically, the organic EL device produces white light by emitting light of three primary colors of red, green, and blue or emitting light of mutually complementary colors, for example blue and yellow.

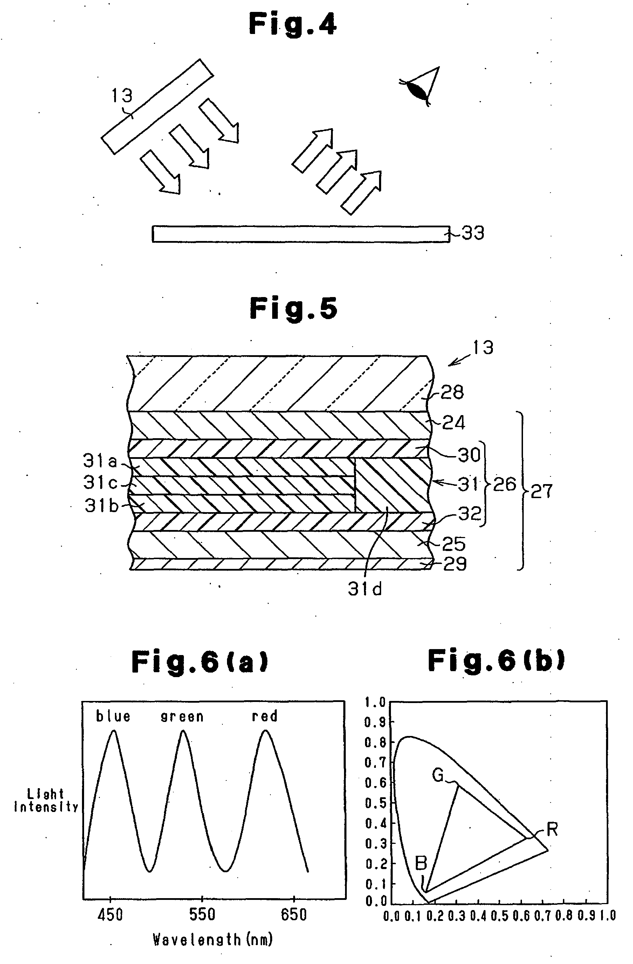

Referring to Fig. 6(a), the emission spectrum of an LED or an organic EL device emitting white light using light of the three primary colors has three peaks corresponding to red light (approximately 620nm), green light (approximately 530nm), and blue light (approximately 455nm). As shown on the x-y chromaticity diagram of Fig. 6(b), each of the three primary colors of light defines an apex of a triangle.

For obtaining further colors, a display apparatus capable of operating with primary colors provided in the number greater than the number of sub-pixels configuring each pixel has been proposed (for example, see Japanese Laid-Open Patent Publication No. 2004-138827). In the apparatus, each pixel is formed by, for example, three sub-pixels. The light source of the apparatus emits six types of light, short wavelength blue (B1), long wavelength blue (B2), short wavelength green (G1), long wavelength green (G2), short wavelength red (R1), and long wavelength red (R2). The display period for displaying each image is divided into two terms, a first term and a second term. The color(s) of the light emitted by the light source and the state of the sub-pixels in the first term are controlled to be different from those of the second term. This makes it possible to display the image using the primary colors provided in the number greater than the number of the sub-pixels.

As compared with the color reproduction range of a liquid crystal color display used in a personal computer or a digital still camera, the color reproduction range of a typical color printed object, particularly, one produced by a broadly used inkjet type printer, indicates a broader zone corresponding to cyan. As a result, if an image is edited by means of the liquid crystal color display and printed by the printer, the printed image provides a different impression from the image viewed on the display.

Further, when a printed object such as a poster or a painting is viewed indoors while being illuminated by the conventional lighting apparatus emitting white light generated from light of the three primary colors, red (R), green (G), and blue (B), the original colors of the printed object or the painting cannot be sufficiently reproduced.

### SUMMARY OF THE INVENTION

Accordingly, it is an objective of the present invention to provide a lighting apparatus capable of reproducing the colors of a color printed object on a liquid crystal color display, and improving color reproduction accuracy for, for example, printed objects or paintings, when they are viewed indoors, as well as a liquid crystal display apparatus having the lighting apparatus.

To achieve the foregoing and other objectives, the present invention provides a lighting apparatus having an organic electroluminescent device as a light source. The organic electroluminescent device includes a pair of electrodes and an organic layer arranged between the electrodes for emitting light when an electric field is applied to the organic layer. An emission spectrum of the organic electroluminescent device has peaks in each of red, green, blue, and cyan wavelength zones.

Another aspect of the present invention is a liquid crystal display apparatus having a liquid crystal panel and a lighting apparatus arranged at the backside of the liquid crystal panel. The liquid crystal panel includes a color filter and a plurality of pixels each including a set of four sub-pixels. The color filter includes a plurality of sets of filter sections, each set including a red filter section, a green filter section, a blue filter section, and a cyan filter section. The four sub-pixels of each set correspond to the red, green, blue, and cyan filter sections of an associated set of filter sections. Further, the lighting apparatus has an organic electroluminescent device as a light source. The organic electroluminescent device includes a pair of electrodes and an organic layer arranged between the electrodes,for emitting light when an electric field is applied to the organic layer. An emission spectrum of the organic electroluminescent device has peaks in each of red, green, blue, and cyan wavelength zones.

Other aspects and advantages of the invention will become apparent from the following description, taken in conjunction with the accompanying drawings, illustrating by way of example the principles of the invention.

### BRIEF DESCRIPTION OF THE DRAWINGS

The invention, together with objects and advantages thereof, may best be understood by reference to the following description of the presently preferred embodiments together with the accompanying drawings in which:
Fig. 1(a) is a view schematically showing a liquid crystal display apparatus according to an embodiment of the present invention;
Fig. 1(b) is a cross-sectional view schematically showing a portion of a liquid crystal panel of the liquid crystal display apparatus of Fig. 1(a);
Fig. 1(c) is a cross-sectional view schematically showing a portion of a lighting apparatus of the liquid crystal display apparatus of Fig. 1(a);
Fig. 2 is a graph representing the spectrum of the light emitted by the lighting apparatus of Fig. 1(c) (as indicated by the solid lines) and the light transmission characteristics of the color filters employed in the liquid crystal panel of Fig. 1(b) (as indicated by the broken lines);
Fig. 3 is an x-y chromaticity diagram showing red light, green light, blue light, and cyan light;
Fig. 4 is a view schematically showing a printed object viewed as illuminated by a lighting apparatus according to a modified embodiment of the present invention;
Fig. 5 is a cross-sectional view schematically showing a portion of a lighting apparatus according to another modified embodiment of the present invention;
Fig. 6(a) is a graph showing the emission spectrum of a conventional white EL device; and
Fig. 6(b) is an x-y chromaticity diagram showing the red light, the green light, and the blue light.

### DETAILED DESCRIPTION OF THE PREFERRED EMBODIMENTS

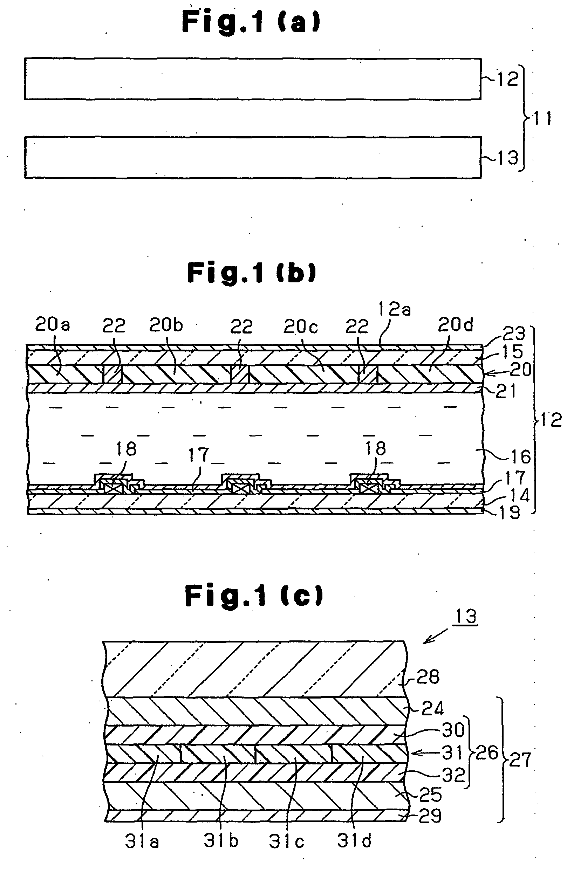

An embodiment of the present invention, or a backlight of a full-color liquid crystal display apparatus, will be described with reference to Figs. 1(a) to 3.

As shown in Fig. 1(a), a liquid crystal display apparatus 11 includes a transmission type liquid crystal panel 12 and a lighting apparatus 13 serving as a backlight. The lighting apparatus 13 is arranged at the backside of the liquid crystal panel 12. In other words, the lighting apparatus 13 is arranged on the surface of the liquid crystal panel 12 that faces away from a display surface (a display screen) of the liquid crystal panel 12.

As shown in Fig. 1(b), the liquid crystal panel 12 has a pair of transparent substrates 14, 15 that are bonded together by a non-illustrated seal material, and spaced at a predetermined interval. A liquid crystal 16 is sealed in the clearance between the substrates 14, 15. Each of the substrates 14, 15 is formed of, for example, glass. The substrate 14 is located at the side corresponding to the lighting apparatus 13. On the surface of the substrate 14 facing the liquid crystal 16, a multiple number of pixel electrodes 17 and thin film transistors (TFTs) 18 connected to the corresponding pixel electrodes 17 are provided. Each of the pixel electrodes 17 is formed of indium tin oxide (ITO). Four of the pixel electrodes 17 configure a single pixel. Further, a polarization plate 19 is formed on the surface of the substrate 14 that is the other surface of the substrate 14 facing the liquid crystal 16.

A color filter 20 is formed on the surface of the substrate 15 facing the liquid crystal 16. A common transparent electrode 21 for the pixels is provided on the color filter 20. The transparent electrode 21 is formed of ITO. The color filter 20 includes a plurality of sets of filter sections, each set consisting of a red filter section 20a, a green filter section 20b, a blue filter section 20c, and a cyan filter section 20d for transmitting red light, green light, blue light, and cyan light, respectively. The four pixel electrodes 17, which form a set, are arranged as opposed to the corresponding filter sections 20a to 20d of the associated filter section set. The adjacent ones of the filter sections 20a to 20d are separated from each other by a black matrix 22. A polarization plate 23 is formed on the surface of the substrate 15 that is the other surface of the substrate 15 facing the liquid crystal 16.

That is, the liquid crystal panel 12 of Fig. 1(b) is configured essentially identical to a known full-color display type liquid crystal panel, except for that each of the pixels includes a set of four sub-pixels (four pixel electrodes 17), and that the sub-pixels of each set are arranged as opposed to the corresponding filter sections 20a to 20d of the associated filter section set.

As shown in Fig. 1(c), the lighting apparatus 13 has an organic EL device 27 as a light source in which an organic layer 26 is arranged between a pair of electrodes 24, 25. The organic layer 26 emits light when an electric field is applied to the organic layer 26. More specifically, the organic EL device 27 is formed by laminating the first electrode 24, the organic layer 26, and the second electrode 25 on a substrate 28 in this order. The organic El device 27 is covered with a protection film 29 for preventing the organic layer 26 from being adversely affected by water (vapor) and oxygen.

In the illustrated embodiment, a transparent glass substrate is employed as the substrate 28. The first electrode 24 serves as an anode and the second electrode 25 as a cathode. The first electrode 24 is formed of ITO (indium tin oxide), which is used for forming a transparent electrode of a known organic EL device, and transmits light. The second electrode 25 is formed of metal (for example, aluminum) and reflects light. The organic EL device 27 is formed as a so-called bottom emission type, or, that is, the light emitted by the organic layer 26 exits the organic EL device 27 through the substrate 28. The protection film 29 is formed of, for example, silicon nitride.

The organic layer 26 is formed by laminating a hole transport layer 30, a light emission layer 31, and an electron transport layer 32 on the first electrode 24 in this order. The light emission layer 31 is formed by a plurality of sets of light emission sections, each set consisting of a red light emission section 31a, a green light emission section 31b, a blue light emission section 31c, and a cyan light emission section 31d. The red, green, blue, and cyan light emission sections 31a to 31d do not overlap with one another along a direction defined by the thickness of the organic layer 26. The light emission sections 31a to 31d are arranged in a striped pattern and extend parallel with one another. The width of each emission section 31a to 31d is substantially equal to the width of the corresponding one of the filter sections 20a to 20d of the color filter 20. More specifically, the light emitted by the red light emission section 31a of the organic EL device 27 is transmitted through the red filter section 20a of the color filter 20, the light emitted by the green light emission section 31b is transmitted through the green filter section 20b, the light emitted by the blue light emission section 31c is transmitted through the blue filter section 20c, and the light emitted by the cyan light emission section 31d is transmitted through the cyan filter section 20d.

In Figs. 1(b) and 1(c), each of which schematically showing the structure of the liquid crystal panel 12 or the lighting apparatus 13 for explanation thereof, the components are shown in accordance with the sizes and proportions modified from the actual sizes and proportions, for the illustration purposes.

In the illustrated embodiment, the hole transport layer 30 is formed by vacuum vapor deposition using triphenylamine tetramer (TPTE) having a methyl group at the meta-position of the terminal phenyl as hole transport material. The electron transport layer 32 is formed by vacuum vapor deposition using tris(8-quinolinol)aluminum, which is called Alq₃, metal complex of an 8-quinolinol derivative, as electron transport material.

The red light emission section 31a is formed by vacuum vapor deposition (co-deposition) by employing TPTE as a host and DCJTB (4-dicyanomethylene-6-cp-julolidinostyryl-2-tert-butyl-4H-pyran) as a dopant (a luminous pigment). The content of DCJTB is set to, for example, 0.5 weight percent with respect to TPTE. Since the pigment formed by DCJTB emits red light, the red light emission section 31a emits the red light.

The green light emission section 31b is formed by vacuum vapor deposition (co-deposition) by employing Alq₃ as a host and quinacridon (Qd) as a dopant (a luminous pigment). Since the pigment formed by Qd emits green light, the green light emission section 31b emits the green light.

The blue light emission section 31c is formed by vacuum vapor deposition (co-deposition) by employing, in the illustrated embodiment, DPVBi (4,4-bis(2,2-diphenyl-ethen-1-yl)-biphenyl) as a host and BCzVBi (4,4'-bis(9-ethyl-3-carbazovinylene)-1,1'-biphenyl) as a dopant (a luminous pigment). The content of BCzVBi is set to, for example, 5.0 weight percent with respect to DPVBi. Since the pigment formed by BCzVBi emits blue light, the blue light emission section 31c emits the blue light.

The cyan light emission section 31d is formed by vacuum vapor deposition using Balq₂ (bis(2-methyl-8-quinolinolato)(p-phenylphenolato)aluminum (III)).

DCJTB and BAlq₂ are represented by the following formulas:

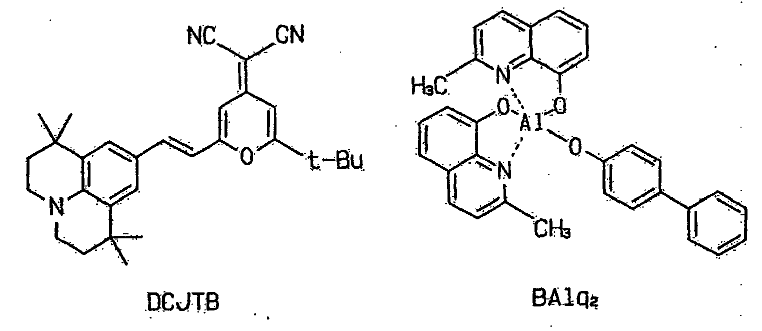

The liquid crystal display 11, which is constructed as above-described, operates as follows.

When the liquid crystal display 11 is turned on to display an image on the display screen of the liquid crystal panel 12, voltage is applied to the liquid crystal 16 corresponding to predetermined pixels associated with the image to be displayed, in response to an instruction signal from a non-illustrated controller. In this manner, the pixels are switched to a display state, or a state capable of transmitting the light (the incident light) from the lighting apparatus 13. The quantity of the light transmitted through the liquid crystal 16 is controlled in correspondence with the level of the applied voltage.

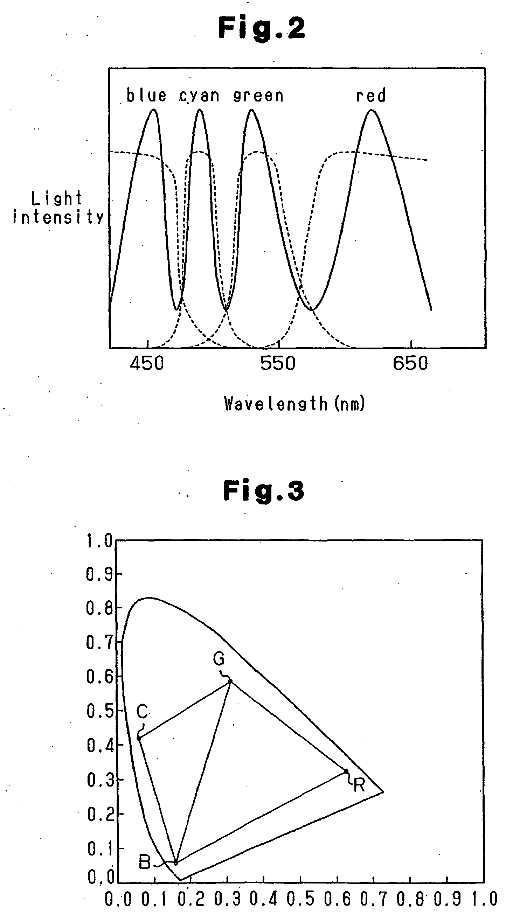

In the lighting apparatus 13, voltage is applied to the first and second electrodes 24, 25, through the controller. All of the light emission sections 31a to 31d of the organic EL device 27 are thus enabled to emit light. More specifically, the red light emission section 31a emits the red light, the green light emission section 31b emits the green light, the blue light emission section 31c emits the blue light, and the cyan light emission section 31d emits the cyan light. The light from each of the light emission sections 31a to 31d exits the lighting apparatus 13 through the substrate 28 and then enters the liquid crystal panel 12 through the substrate 14. As indicated by the solid line in Fig. 2, the light exiting the lighting apparatus 13, in other words, the light emitted by the organic EL device 27, has peaks of light intensity corresponding to blue, cyan, green, and red in this order from the side of a short wavelength in its emission spectrum. In the illustrated embodiment, the wavelength of the peak in the blue wavelength zone is approximately 455nm, the wavelength of the peak in the cyan wavelength zone is approximately 495nm, the wavelength of the peak in the green wavelength zone is approximately 530nm, and the wavelength of the peak in the red wavelength zone is approximately 620nm.

When voltage is applied to the pixel electrodes 17, the light is transmitted through the liquid crystal 16 by the quantity corresponding to the level of the voltage. The light then passes through the transparent electrode 21 and is transmitted through the filter sections 20a to 20d of the color filter 20. The image formed by the light transmitted through the color filter 20 is thus visibly recognized as the image displayed by the liquid crystal display 11. An example of the light transmission characteristics of the filter sections 20a to 20d of the color filter 20 is indicated by the broken lines of Fig. 2.

For displaying a color image, the colors of the image are adjusted as desired by mixing the three primary colors of red, green and blue and the cyan color, which are defined by the corresponding pixels. In the illustrated embodiment, the quantity of the light exiting the lighting apparatus 13 is constant. And, the quantity of the light transmitted through the section of the color filter 20 corresponding to each pixel, or the mixing proportion of the red, green, blue, and cyan colors in each pixel, is adjusted in correspondence with the level of the voltage applied to the pixel electrodes 17.

As indicated by the x-y chromaticity diagram of Fig. 3, each color reproduced by the three primary colors falls in the range of the triangle (RGB) formed by the apex corresponding to the coordinates of the peak in red (R) wavelength zone, the apex corresponding to the coordinates of the peak in green (G) wavelength zone, and the apex corresponding to the coordinates of the peak in blue (B) wavelength zone. Contrastingly, a majority of the cyan type colors produced by cyan ink in color printed objects are outside the triangle (RGB). Therefore, the colors of the color printed objects cannot be accurately reproduced by mixing of the light of the three primary colors.

However, in addition to the light emission sections 31a to 31c corresponding to the three primary colors, the lighting apparatus 13 of the illustrated embodiment includes the cyan light emission section 31d emitting the light of the cyan (C), which is not included in the range corresponding to the triangle (RGB). Thus, each color reproduced by the three primary colors and the cyan falls in the range of the square (RGCB) of Fig. 3, which is defined by the apex corresponding to the coordinates of the peak in red (R) wavelength zone, the apex corresponding to the coordinates of the peak in green (G) wavelength zone, the apex corresponding to the coordinates of the peak in cyan (C) wavelength zone, and the apex corresponding to the coordinates of the peak in blue (B) wavelength zone. In other words, the range of the triangle (GCB), which is defined outside the range of the triangle (RGB), is added to the color space. Accordingly, a majority of the cyan type colors produced by cyan ink in the color printed objects is included in the color space reproduced by the light generated by the lighting apparatus 13. As a result, as compared to the conventional case in which color adjustment is carried out using the light of the three primary colors, the colors of the color printed objects are reproduced accurately in the illustrated embodiment.

The illustrate embodiment has the following advantages.
(1) The lighting apparatus 13, which is used as the backlight of the liquid crystal display 11, includes the organic EL device 27 in which the organic layer 26 is arranged between the electrodes 24, 25, as the light source. The organic layer 26 emits light when an electric field is applied to the organic layer 26. The emission spectrum of the organic EL device 27 includes the peak in the cyan color wavelength zone, in addition to the peaks in the red, green, and blue wavelength zones. Thus, unlike a conventional backlight for a color monitor which emission spectrum does not have a peak in the cyan wavelength zone, the cyan type colors of the printed objects are accurately reproduced on the screen of the liquid crystal panel 12. Further, even when printing an image captured by a digital still camera, edited through the liquid crystal display 11, and subjected to color adjustment through the screen of the liquid crystal panel 12, the obtained image is substantially unchanged from the original image viewed on the liquid crystal panel 12.
(2) If the wavelength of the peak in the cyan wavelength zone is excessively close to the wavelength of the peak in the green or blue wavelength zone, color expression (color adjustment) cannot be performed effectively by mixing the cyan light with the green or blue light. However, since the wavelength of the peak in the cyan wavelength zone is in the range of 485 to 505nm, the color adjustment may be carried out effectively by mixing the cyan color with a different color.
(3) In the organic layer 26, the light emission sections 31a to 31d are arranged without overlapping with one another along a direction defined by the thickness of the organic layer 26. This arrangement makes it possible for the organic EL device 27 as the light source to produce the light reliably having the emission spectrum with the peaks corresponding to the red, the green, the blue, and the cyan.

The present invention is not restricted to the illustrated embodiment but may be embodied in the following modified forms.

The lighting apparatus 13 may be used for illuminating purposes indoors. If the lighting apparatus 13 is used as the backlight of the liquid crystal display 11, the width of each emission section 31a to 31d must be substantially equal to the width of the corresponding sub-pixel of the liquid crystal panel 12. Thus, for reproducing an image precisely, the width of the emission section 31a to 31d must be reduced in correspondence with the width of the sub-pixel. However, if the lighting apparatus 13 is used for illuminating purposes, the width of each emission section 31a to 31d may be relatively large as compared to the illustrated embodiment, as long as the light emitted by the emission sections 31a to 31d cannot be visibly recognized as the lights of the independent colors of red, green, blue, and cyan. When the lighting apparatus 13 is used for viewing a printed object 33 or a painting, the lighting apparatus 13 emits the light spectrum of which has the peaks in the red, green, blue, and cyan wavelength zones. Thus, even if the printed object 33 includes a cyan type color adjusted by mixing cyan ink, the colors of the printed object 33 can be reproduced accurately.

If the lighting apparatus 13 is used for viewing printed objects or paintings, a diffusion portion such as a diffusion plate or a diffusion layer may be provided on the light exit surface. In this case, the width of each light emission section 31a to 31d can be increased as compared to the case in which the diffusion portion is not provided. This facilitates formation of the emission sections 31a to 31d.

The light emission layer 31 of the organic EL device 27 does not necessarily have to be configured as in the illustrated embodiment, in which the light emission sections 31a to 31d are arranged without overlapping with one another along the direction defined by the thickness of the organic layer 26. For example, as shown in Fig. 5, the red light emission section 31a, the blue light emission section 31c, and the green light emission section 31b may be consecutively laminated on the hole transport layer 30 in this order, in an overlapping manner. Contrastingly, the cyan light emission section 31d is laminated on the hole transport layer 30 without overlapping with the remaining light emission sections 31a to 31c. With regard to the structure in which the red light emission section 31a, the green light emission section 31b, and the blue light emission section 31c are deposited in an overlapping manner, multiple types of organic materials that reliably emit the white light which emission spectrum has the peaks in the red, green, and blue wavelength zones when voltage is applied to the electrodes 24, 25 are known. Thus, this structure may be employed without causing a problem. Further, the order in which the light emission sections 31a to 31c are arranged is not restricted to the order indicated in Fig. 5.

If the cyan light emission section 31d can be laminated in an overlapping manner with the other light emission sections 31a to 31c without causing a problem regarding the peaks indicated by the emission spectrum, the light emission sections 31a to 31d may overlap with one another. In this case, the width of each of the light emission sections 31a to 31d does not have to be substantially equal to the width of the corresponding one of the pixel electrodes 17. This makes it easier to form the light emission sections 31a to 31d.

The organic materials forming the hole transport layer 30 and the electron transport layer 32, which form the organic layer 26, are not restricted to those of the illustrated embodiment. The material for forming the hole transport layer 30 may be selected from, for example, low molecular materials such as metal or non-metal phthalocyanines such as copper phthalocyanine and tetra(t-butyl)copper phthalocyanine, quinacridone compounds, and aromatic amines such as 1,1-bis(4-di-p-tolylaminophenyl)cyclohexane, N,N'-diphenyl-N,N'-bis(3-methylphenyl)-1,1'-biphenyl-4,4'-diamine, and N,N'-di(1-naphthyl)-N,N'-diphenyl-1,1'-biphenyl-4,4'-diamine, polymeric materials such as polythiophene and polyaniline, polythiophene oligomer materials, and other existing hole transport materials.

The material for forming the electron transport layer 32 may be, for example, oxadiazole derivatives such as 2-(4-biphenylyl)-5-(4-t-butylphenyl)-1,3,4-oxadiazole and 2,5-bis(1-naphthyl)-1,3,4-oxadiazole, bis(10-hydroxybenzo[h]quinolinolato)beryllium complex, and triazole compounds.

Similarly, the organic materials for forming the light emission sections 31a to 31c are not restricted to those of the illustrated embodiment but may be replaced by existing light emission materials. The material of the red light emission section 31a may be, for example, TPTE as a host and DCJT as a dopant. DCJT is formed by converting the tert-butyl group of DCJTB into a methyl group. The material of the green light emission section 31b may be, for example, Alq₃ or benzoquinolinol beryllium complex (Bebq₂). Alternatively, the material of the green light emission section 31b may be Alq₃ as a host and 10-(2-benzothiazolyl)-2,3,6,7-tetrahydro-1,1,7,7-tetramethyl-1H,5H,11H-[1]benzopyrano[6,7,8-ij]quinolizine-11-one, which is called C545T, as a dopant. The title C545T is a trade name of Eastman-Kodak Corporation. The material for forming the blue light emission section 31c may be, for example, benzoxazol complex of zinc (Zn(oxz)₂).

The organic layer 26 does not necessarily have to consist of the triple layers, or the hole transport layer 30, the light emission layer 31, and the electron transport layer 32. For example, a hole injection layer may be arranged between the first electrode 24 (the anode) and the hole transport layer 30. Further, an electron injection layer may be provided between the electron transport layer 32 and the second electrode 25 (the cathode). Alternatively, a hole injection transport layer may be arranged at one side of the light emission layer 31 and an electron injection transport layer may be provided at the opposite side. Also, the organic layer 26 may include a buffer layer or a hole block layer, which may be employed in a known organic EL layer. These layers may be formed of a known material by a known method. Further, depending on the material forming the light emission layer 31, the organic layer 26 may be formed simply by the light emission layer 31.

The organic EL device 27 is not restricted to the bottom emission type but may be a so-called top emission type in which the light emitted by the organic layer 26 exits the organic EL device 27 from the side opposite to the substrate 28. In this case, the second electrode 25 is formed by a transparent electrode but the first electrode 24'may be formed either by a transparent electrode or an opaque electrode. The substrate 28 is not restricted to the transparent type but may be an opaque type. For improving the efficiency of electron injection from the cathode, it is generally preferred that the work function of the material forming the cathode be 4.0eV or lower. However, the work function of ITO is 4.8eV. Thus, if the second electrode 25 is formed of ITO, it is preferred that the electron transport layer 32 is provided closer to the light emission layer 31 between the light emission layer 31 and the second electrode 25 and the electron injection layer is provided closer to the second electrode 25 between the light emission layer 31 and the second electrode 25. Further, since a material with improved work function facilitates injection of holes, it is preferred that the anode be formed of this type of material. Although ITO is preferred as the material of the anode, the first electrode 24 of the top emission type organic EL device 27 dose not necessarily have to be transparent and thus may be formed of metal having resistance smaller than the ITO. Regarding the work function of metal (represented by unit eV), chrome indicates 4.5, nickel 5.15, gold 5.1, palladium 5.55, copper 4.65, aluminum 4.28, and magnesium 3.36. Thus, if the first electrode 24 is formed of metal, it is preferred that a hole injection layer is provided between the hole transport layer 30 and the first electrode 24.

If the organic El device 27 is the bottom emission type, the second electrode 25 does not necessarily have to reflect light. However, if the second electrode 25 reflects light, the light emitted from the light emission layer 31 to the second electrode 25 is reflected by the second electrode 25 and exits from the first electrode 24. Thus, the quantity of the light emitted from the organic EL device 27 becomes relatively large, as compared to the case in which the light reflected by the second electrode 25 is not used.

The material of the protection film 29 is not restricted to silicon nitride but may be any suitable substance as long as the organic layer 26 is protected from the oxygen and water from the exterior. The protection film 29 thus may be formed of silicon oxide or diamond-like carbon or polymeric material. Further, instead of the protection film 29, a glass cover or a metal cover may cover the portion of the organic EL device 27 other than the portion opposed to the substrate 28.

The configuration of each pixel of the liquid crystal panel 12 is not restricted to the structure in which four rectangular sub-pixels are arranged parallel with one another. Alternatively, for example, the four sub-pixels may be divided into two pairs of sub-pixels, in each of which the sub-pixels are arranged side by side. The sub-pixels are then arranged in such a manner that one of the pairs of sub-pixels is opposed to the other. Further, the shape of each sub-pixel is not restricted to the square shape but may be different shapes including a triangular shape or a hexagonal shape. In this case, the shape of each light emission section 31a to 31d must be modified correspondingly.

The present examples and embodiments are to be considered as illustrative and not restrictive and the invention is not to be limited to the details given herein, but may be modified within the scope and equivalence of the appended claims.

A liquid crystal display apparatus (11) has a liquid crystal panel (12) and a lighting apparatus (13) arranged at the backside of the liquid crystal panel. The lighting apparatus has an organic electroluminescent device (27) as a light source. The organic electroluminescent device includes a pair of electrodes (24, 25) and an organic layer (26) arranged between the electrodes for emitting light when an electric field is applied to the organic layer. An emission spectrum of the organic electroluminescent device has peak in each of red, green, blue, and cyan wavelength zones. Therefore, the colors of printed objects on the liquid crystal display are accurately reproduced.

## Claims

1. A lighting apparatus having an organic electroluminescent device (27) as a light source, wherein the organic electroluminescent device includes a pair of electrodes (24, 25) and an organic layer (26) arranged between the electrodes for emitting light when an electric field is applied to the organic layer, the lighting apparatus being **characterized in that** an emission spectrum of the organic electroluminescent device has peaks in each of red, green, blue, and cyan wavelength zones.

2. The lighting apparatus according to Claim 1, **characterized in that** the cyan wavelength zone is in the range of 485 to 505nm.

3. The lighting apparatus according to Claim 1, **characterized in that** the cyan wavelength zone corresponds to a wavelength zone of a light having a chromaticity outside a triangle defined by apexes each corresponding to coordinate of one of the peaks in the red, green, and blue wavelength zones, in an x-y chromaticity diagram.

4. The lighting apparatus according to any one of Claims 1 to 3, **characterized in that** the organic layer includes a plurality of red light emission sections (31a), green light emission sections (31b), blue light emission sections (31c), and cyan light emission sections (31d), and wherein the red, green, blue, and cyan light emission sections are arranged without overlapping with one another along a direction defined by the thickness of the organic layer.

5. The lighting apparatus according to any one of Claims 1 to 3, **characterized in that** the organic layer includes a plurality of sets of light emission sections, each set including a red light emission section (31a), a green light emission section (31b), a blue light emission section (31c), and a cyan light emission section (31d), and wherein the red, green, and blue light emission sections of each of the sets are laminated along a direction defined by the thickness of the organic layer and are arranged without overlapping with the cyan light emission section of the set along the direction defined by the thickness of the organic layer.

6. The lighting apparatus according to any one of Claims 1 to 5, **characterized in that** the lighting apparatus is used as a backlight of a liquid crystal display apparatus.

7. A liquid crystal display apparatus, **characterized by:**
a liquid crystal panel (12), the liquid crystal panel including a color filter (20) and a plurality of pixels each including a set of four sub-pixels (17), the color filter including a plurality of sets of filter sections, each set including a red filter section (20a), a green filter section (20b), a blue filter section (20c), and a cyan filter section (20d), wherein the four sub-pixels of each set correspond to the red, green, blue, and cyan filter sections of an associated set of filter sections; and
the lighting apparatus according to any one of Claims 1 to 3, the lighting apparatus arranged at the backside of the liquid crystal panel.

8. The liquid crystal display apparatus according to Claim 7, **characterized in that** the organic layer includes a plurality of sets of light emission sections, each set including a red light emission section (31a), a green light emission section (31b), a blue light emission section (31c), and a cyan light emission section (31d), wherein the red, green, blue, and cyan light emission sections of each of the sets of light emission sections correspond respectively to the red, green, blue, and cyan filter sections of an associated set of filter sections, and wherein the red light emission sections, the green light emission sections, the blue light emission sections, and the cyan light emission sections are arranged without overlapping with one another along a direction defined by the thickness of the organic layer.

9. The liquid crystal display apparatus according to Claim 8, **characterized in that** the red light emission sections, the green light emission sections, the blue light emission sections, and the cyan light emission sections are arranged in a striped pattern and extend parallel with one another, and a width of each of the light emission sections is substantially equal to a width of a corresponding one of the red, green, blue, and cyan filter sections.

10. The liquid crystal display apparatus according to Claim 7, **characterized in that** the organic layer includes a plurality of sets of light emission sections, each set including a red light emission section (31a), a green light emission section (31b), a blue light emission section (31c), and a cyan light emission section (31d), wherein the red, green, blue, and cyan light emission sections of each of the sets of light emission sections correspond respectively to the red, green, blue, and cyan filter sections of an associated set of filter sections, and wherein the red, green, and blue light emission sections of each of the sets of light emission sections are laminated along a direction defined by the thickness of the organic layer and are arranged without overlapping with the cyan light emission section of the set of light emission sections along the direction defined by the thickness of the organic layer.
